# EUROPÄISCHE PATENTANMELDUNG

(11) **EP 3 708 416 A1**
(43) Veröffentlichungstag der Anmeldung: **16.09.2020**
(21) Anmeldenummer: 20020024.4
(22) Anmeldetag: 17.01.2020
(51) Int. Cl.: B60L 58/10, B60L 58/12, B60L 58/16

(54) **VERFAHREN UND LADEEINRICHTUNG ZUR BESTIMMUNG EINER MAXIMALEN SPEICHERKAPAZITÄT EINES ENERGIESPEICHERS**

(30) Priorität: 12.03.2019 DE 102019106240
(71) Anmelder: Dr. Ing. h.c. F. Porsche AG, 70435 Stuttgart (DE)
(72) Erfinder: Heyne, Raoul, 75446 Wiernsheim (DE); Volk, Dominik, 76199 Karlsruhe (DE)

(57) **Zusammenfassung**

Die Erfindung betrifft ein Verfahren zur Bestimmung einer maximalen Speicherkapazität eines Energiespeichers (28), insb. als Antriebsbatterie eines Fahrzeugs (26) mit einem elektrischen Antrieb, umfassend die Schritte Ermitteln eines Ladezustands des Energiespeichers (28) des Fahrzeugs (26), Laden des Energiespeichers (28) bis zum Erreichen seiner maximalen Ladungsmenge, vollständiges Entladen des Energiespeichers (28) unter Verwendung einer separaten Energiespeichereinheit (20) zur Aufnahme der Ladung des Energiespeichers (28), wobei eine von dem Energiespeicher (28) in die Energiespeichereinheit (20) übertragene Ladungsmenge erfasst wird, und Ausgeben der übertragenen Ladungsmenge beim vollständigen Entladen des Energiespeichers (28) als max. Kapazität des Energiespeichers (28). Die Erfindung betrifft weiterhin eine Ladeeinrichtung (10) zum Schnellladen eines Energiespeichers (28), insb. als Antriebsbatterie eines Fahrzeugs (26) mit einem elektrischen Antrieb, umfassend eine Ladesäule (22), und eine Chargebox (12), die zwischen einem Energienetz (14) und der Ladesäule (22) verbunden ist, und der Ladesäule (22) elektrische Energie zum Schnellladen mit hohen Gleichspannungen und Gleichströmen bereitstellt, wobei die Chargebox (12) eine Energiespeichereinheit (20) aufweist, und die Ladeeinrichtung (10) ausgeführt ist, das obige Verfahren durchzuführen.

## Beschreibung

Die vorliegende Erfindung betrifft ein Verfahren zur Bestimmung einer maximalen Speicherkapazität eines Energiespeichers, insbesondere als Antriebsbatterie eines Fahrzeugs mit einem elektrischen Antrieb.

Weiterhin betrifft die Erfindung eine Ladeeinrichtung zum Schnellladen eines Energiespeichers, insbesondere als Antriebsbatterie eines Fahrzeugs mit einem elektrischen Antrieb, umfassend eine Ladesäule, und eine Chargebox, die zwischen einem Energienetz und der Ladesäule verbunden ist, und der Ladesäule elektrische Energie zum Schnellladen mit hohen Gleichspannungen und Gleichströmen bereitstellt, wobei die Chargebox eine Energiespeichereinheit aufweisen kann, und die Ladeeinrichtung ausgeführt ist, das obige Verfahren durchzuführen.

Die vorliegende Erfindung betrifft insbesondere das Gebiet zum Schnellladen von Fahrzeugen mit einem elektrischen Antrieb mit hohen Gleichspannungen und -strömen, wo große elektrische Leistungen zum Schnellladen von Elektrofahrzeugen bereitgestellt werden. Das Schnellladen wird beispielsweise mit einer sogenannten Chargebox (CBX) durchgeführt. Die CBX stellt beispielsweise zusammen mit ein bis zwei anschließbaren Ladesäulen eine "kleine Ladelösung" dar.

Die CBX umfasst dabei beispielsweise ein bis zwei Leistungselektroniken und eine Kühleinheit. Außerdem kann die CBX eine interne Energiespeichereinheit aufweisen. Die Energiespeichereinheit kann beispielsweise als Booster verwendet werden, um das Laden der Fahrzeuge zu beschleunigen. Entsprechend kann die interne Energiespeichereinheit mit kleinen Leistungen von einem Energienetz geladen werden, um im geladenen Zustand eine größere Leistung als Kombination von Netz- und Batterieleistung zum Laden der Fahrzeuge zur Verfügung zu stellen.

Die verschiedenen Ladestationen, die weltweit im Einsatz sind, haben oft geringe Ladeleistungen und beziehen diese meistens direkt aus dem Energienetz.

Die Elektrofahrzeuge besitzen eine Batterie als Energiespeicher, wobei es erforderlich oder zumindest wünschenswert sein kann, die Kapazität der Batterie zu überprüfen. Dazu ist die Batterie vollständig zu laden und zu entladen. Dies ist jedoch sehr aufwendig und mit hohen Kosten verbunden. Allerdings kann sich die maximale Kapazität der Batterie durch Alterungseffekte über die Zeit ändern, so dass es wünschenswert ist, die maximale Kapazität der Batterie zu überprüfen.

Die maximale Kapazität der Batterien von Fahrzeugen mit elektrischen Antrieben wird daher häufig anhand von Fahrdaten ermittelt. Eine vollständige und genaue Kapazitätsermittlung ist so jedoch nicht möglich. Eine genaue Kapazitätsprüfung von Batterien ist mit einem Prüfstand möglich, wozu die Batterien typischerweise ausgebaut werden müssen. Nur so können die Batterien zuverlässig vermessen werden. Die in der Fahrzeugbatterie gespeicherte Energie wird dabei üblicherweise ins Energienetz zurückgespeist.

In diesem Zusammenhang ist aus der US 2011 313 613 A1 eine elektrische Speichervorrichtung mit einer Zustandserfassungseinheit bekannt, die den Zustand einer Batterieeinheit verwaltet und steuert. Die Zustandserfassungseinheit erfasst eine Zwischenklemmenspannung jeder einzelnen einer Vielzahl von Batterien, die von einer Batterieverwaltungseinheit in einem Leerlaufzustand gemessen wird, in dem die Batterieeinheit von einer Last getrennt ist, und Variationsinformationen über die Ladezustände der Batterien berechnet. Darüber hinaus berechnet die Zustandserfassungseinheit unter Berücksichtigung der Variationsinformationen über die Ladezustände der Batterien zulässige Lade- und Entladeinformationen, die zum Steuern des Ladens und Entladens der Batterieeinheit in einem geladenen Zustand erforderlich sind. Dazu wird die Batterieeinheit mit einer Last verbunden und geladen oder entladen, und gibt die zulässigen Lade- und Entladeinformationen an eine Lade- und Entladeeinrichtung in der Batterieeinheit aus.

Gemäß der US 2012 004 798 A1 beinhaltet eine Entladesteuerungsvorrichtung in einem Elektromotorrad eine Hauptbatterie; einen Motor, der basierend auf der von der Hauptbatterie gelieferten elektrischen Energie angetrieben wird, und eine Beleuchtungsvorrichtung, die eine andere Last als der Motor zur Wandlung von elektrischer Energie ist. Ein BMU ermittelt eine Restkapazität der Hauptbatterie. Ein Steuerelement führt eine Entladekontrolle der Hauptbatterie durch, um den Motor und die Beleuchtungsvorrichtung mit elektrischer Energie zu versorgen. Das BMU und das Steuerelement erlauben die Entladung der Hauptbatterie, bis die verbleibende Kapazität zu einem Schwellenwert größer als Null wird. Wenn das Steuerelement von einer externen Prüfeinrichtung eine Anweisung erhält, einen Verschlechterungszustand der Hauptbatterie zu überprüfen, führt das Steuerelement eine Entladung der Hauptbatterie durch, bis die verbleibende Kapazität Null erreicht, und lässt dann die Hauptbatterie vollständig aufgeladen werden, um eine ladbare Kapazität zu bestimmen.

Die US 2013 124 029 A1 betrifft eine Steuerung für ein Fahrzeug mit einer Batterie, einer Last, einer elektrischen Leistungssteuerung, die die zwischen der Batterie und der Last ausgetauschte elektrische Leistung steuert, und einem Ladegerät, das die Batterie unter Verwendung einer Stromversorgung außerhalb des Fahrzeugs lädt. Die Steuerung beinhaltet Steuern der elektrischen Leistungssteuerung, so dass ein SOC, das Verhältnis aus tatsächlicher Ladung zur vollen Ladekapazität, in einen vorbestimmten Bereich fällt; Steuern der elektrischen Leistungssteuerung und des Ladegeräts, wenn die Leistungsversorgung mit dem Fahrzeug verbunden ist, so dass ein erweitertes Laden durchgeführt wird, bei dem eine Variation des SOC während des externen Ladens größer als eine Breite des vorbestimmten Bereichs ist; und Berechnen der vollen Ladekapazität durch Multiplizieren eines Verhältnisses eines Maximalwerts des SOC zu einer Variation des SOC während der erweiterten Ladung mit einem akkumulierten Wert des Stroms, der während der erweiterten Ladung in die Batterie fließt.

Die US 2015 081 122 A1 betrifft ein Verfahren zur Reduzierung des Spitzenenergieverbrauchs eines Stromverbrauchers. Das Verfahren umfasst die Vorprogrammierung einer tatsächlichen Verbrauchsleistung basierend auf dem tatsächlichen Stromverbrauch, wobei die tatsächliche Verbrauchsleistung eine Spitzenstartzeit, eine Spitzenendzeit und eine Spitzenverbrauchszeit aufweist; das Bestimmen einer Verbindungsdauer einer Batterie eines Fahrzeugs zu einer Ladestation des Stromverbrauchers; das Bestimmen einer verfügbaren Energie zwischen der erforderlichen Abfahrenergie der Batterie und der Verbindungsenergie; das Bestimmen einer durchschnittlichen erwarteten Verbrauchsleistung, die den tatsächlichen Stromverbrauch über die Verbindungsdauer mittelt; und das Bestimmen einer Lade-/Entladelinie durch Einstellen der durchschnittlichen erwarteten Verbrauchsleistung basierend auf der verfügbaren Energie und der Verbindungsdauer.

Gemäß der US 2016 288 648 A1 wird zum Testen einer Traktionsbatterie eines Elektrofahrzeugs, die über eine Lade-Entladeschnittstelle sowohl ladbar als auch entladbar ist, ein Steuerbefehl zum Einleiten eines Entladevorgangs der Traktionsbatterie erzeugt. Der Entladevorgang wird von einer Prüfeinrichtung überwacht. In Abhängigkeit vom überwachten Entladevorgang wird mindestens eine Kenngröße der Traktionsbatterie bestimmt.

Ausgehend von dem oben genannten Stand der Technik liegt der Erfindung somit die Aufgabe zugrunde, ein Verfahren und eine Ladeeinrichtung der oben genannten Art anzugeben, die eine einfache und zuverlässige Bestimmung einer maximalen Speicherkapazität eines Energiespeichers, insbesondere als Antriebsbatterie eines Fahrzeugs mit einem elektrischen Antrieb, der oben genannten Art ermöglichen.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Verfahren zur Bestimmung einer maximalen Speicherkapazität eines Energiespeichers, insbesondere als Antriebsbatterie eines Fahrzeugs mit einem elektrischen Antrieb, vorgesehen, umfassend die Schritte Ermitteln eines Ladezustands des Energiespeichers des Fahrzeugs, Laden des Energiespeichers bis zum Erreichen seiner maximalen Ladungsmenge, vollständiges Entladen des Energiespeichers unter Verwendung einer separaten Energiespeichereinheit zur Aufnahme der Ladung oder zumindest eines Teils der Ladung des Energiespeichers, wobei eine von dem Energiespeicher z.B. in die Energiespeichereinheit übertragene Ladungsmenge erfasst wird, und Ausgeben der übertragenen Ladungsmenge beim vollständigen Entladen des Energiespeichers als maximale Kapazität des Energiespeichers.

Erfindungsgemäß ist somit außerdem eine Ladeeinrichtung zum Schnellladen eines Energiespeichers, insbesondere als Antriebsbatterie eines Fahrzeugs mit einem elektrischen Antrieb, vorgesehen, umfassend eine Ladesäule, und eine Chargebox, die zwischen einem Energienetz und der Ladesäule verbunden ist, und der Ladesäule elektrische Energie zum Schnellladen mit hohen Gleichspannungen und Gleichströmen bereitstellt, wobei die Chargebox eine Energiespeichereinheit aufweist, und die Ladeeinrichtung ausgeführt ist, das obige Verfahren durchzuführen.

Grundidee der vorliegenden Erfindung ist es also, die maximale Kapazität eines Energiespeichers dadurch zu berechnen, dass der vollständig geladene Energiespeicher vollständig entladen wird, wobei durch die Energiespeichereinheit Ladung aus dem Energiespeicher zwischengespeichert werden kann. Beim Vollständigen Entladen des Energiespeichers kann die maximale Kapazität des Energiespeichers gegenüber anderen Verfahren, welche die maximale Kapazität des Energiespeichers lediglich anhand von Lade- bzw. Entladecharakteristika schätzen, besonders zuverlässig bestimmt werden. Dabei ist das Verfahren auch besonders kostengünstig durchzuführen, da aufgrund der Energiespeichereinheit die elektrische Ladung aus dem Energiespeicher in der Regel nicht abgeleitet oder anderweitig umgewandelt werden muss, sondern eine Zwischenspeicherung erfolgen kann. Außerdem können sowohl das Laden wie auch das Entladen in einer besonders kurzen Zeit durchgeführt werden, da die Energiespeichereinheit als Booster sowohl für das Laden wie auch für das Entladen des Energiespeichers verwendet werden kann, wenn z.B. nur ein kleiner Netzanschluss (d.h. mit geringer Ladeleistung) vorliegt.

Die maximale Kapazität des Energiespeichers wird durch einen Energiefluss bei der Entladung des Energiespeichers bestimmt. Es werden beispielsweise ein Entladestrom und eine Entladespannung gemessen, wodurch die entladene Energiemenge bestimmt und so auf die maximale Kapazität des Energiespeichers geschlossen werden kann. Die Messung kann in der Chargebox erfolgen. Alternativ oder zusätzlich kann beispielsweise ein in der Ladesäule installiertes DC-Meter verwendet werden, um den Entladestrom und die Entladespannung möglichst unmittelbar und geeicht zu messen.

Um sicherzustellen, dass die maximale Speicherkapazität des Energiespeichers korrekt bestimmt werden kann, ist es erforderlich, dass der Energiespeicher stets aus einem Zustand voller Ladung entladen wird. Daher wird zunächst der Ladezustand des Energiespeichers des Fahrzeugs ermittelt, so dass der Energiespeicher bis zum Erreichen seiner maximalen Ladungsmenge geladen werden kann.

Der Energiespeicher ist insbesondere eine Antriebsbatterie eines elektrisch antreibbaren Fahrzeugs. Das Fahrzeug kann ausschließlich einen elektrischen Antrieb aufweisen, oder als sogenanntes Hybridfahrzeug zusätzlich beispielsweise einen Verbrennungsmotor aufweisen. Der Energiespeicher kann eine beliebige Anzahl einzelner Batteriezellen aufweisen, die in gewünschter Weise parallel und/oder in Reihe geschaltet sind, um beispielsweise eine gewünschte Kombination aus maximaler Spannung, maximalem Strom und maximaler Speicherkapazität zu erreichen.

Die Ladeeinrichtung ist zum Schnellladen mit Gleichspannung und Gleichstrom ausgeführt. Die Ladeeinrichtung umfasst eine oder mehrere Ladesäulen, die von der Chargebox mit elektrischer Energie zum Schnellladen mit hohen Gleichspannungen und Gleichströmen versorgt wird oder werden. Bei einer Anwendung beispielsweise im Heimbereich können so beispielsweise eine Mehrzahl Fahrzeuge mit der Ladeeinrichtung verbunden und beispielsweise über Nacht gemeinsam parallel oder nacheinander geladen werden. Entsprechend kann die Ladeeinrichtung an ein Hausnetz als Energienetz angeschlossen sein.

Der Anschluss an das Energienetz erfolgt über die Chargebox. Die Energiespeichereinheit der Chargebox kann eine beliebige Anzahl einzelner Batteriezellen aufweisen, die in gewünschter Weise parallel und/oder in Reihe geschaltet sind, um beispielsweise eine gewünschte Kombination aus maximaler Spannung, maximalem Strom und maximaler Speicherkapazität zu erreichen. Die Energiespeichereinheit hat vorzugsweise eine maximale Kapazität, die größer ist, z.B. 50% oder 100% größer, als die maximal mögliche Kapazität des Energiespeichers. Dabei kann beispielsweise eine durchschnittliche maximale Kapazität des Energiespeichers angenommen werden. Insbesondere im Heimbereich, wenn immer dasselbe Fahrzeug oder dieselben Fahrzeuge geladen wird/werden, kann die Energiespeichereinheit entsprechend an den oder die Energiespeicher dieses/dieser Fahrzeuge angepasst sein. Die Energiespeichereinheit der Chargebox dient einerseits als Booster, um ein Laden bzw. Entladen des Energiespeichers mit einer gegenüber dem Netzanschluss allein erhöhten Leistung durchzuführen. Alternativ oder zusätzlich kann die Energiespeichereinheit der Chargebox verwendet werden, um beispielsweise Energie zum Laden des Energiespeichers zwischen zu speichern. Dies kann sinnvoll sein, wenn die Verfügbarkeit elektrischer Energie und/oder ein Preis der verfügbaren elektrischen Energie Schwankungen unterliegen. Damit kann der Energiespeicher stets mit günstiger elektrischer Energie geladen werden.

In vorteilhafter Ausgestaltung der Erfindung umfasst das Verfahren einen zusätzlichen Schritt zum Laden des Energiespeichers unter Verwendung der separaten Energiespeichereinheit zur Abgabe von Ladung an den Energiespeicher. Der Energiespeicher ist nach der Bestimmung der maximalen Kapazität beim Entladen vollständig entladen, so dass vorzugsweise unmittelbar nach der Bestimmung der maximalen Kapazität beim Entladen der Energiespeicher wieder geladen wird, so dass das Fahrzeug wieder verwendbar ist und auch die maximale Kapazität beim Laden des Fahrzeugs ermittelt wird. Um das Laden möglichst kostengünstig durchführen zu können, wird vorzugsweise elektrische Energie aus der Energiespeichereinheit in den Energiespeicher übertragen, welche vorzugsweise beim Entladen der Antriebsbatterie zuvor mit dieser Energie geladen worden ist.

In vorteilhafter Ausgestaltung der Erfindung umfasst das Verfahren einen zusätzlichen Schritt zum Entladen der separaten Energiespeichereinheit, insbesondere zum Laden des Energiespeichers. Dadurch kann in der Energiespeichereinheit gespeicherte Ladung verwendet werden, um den Energiespeicher zu laden, so dass dieser vollständig geladen werden kann. Eine Rückspeisung von in der Energiespeichereinheit gespeicherter elektrischer Energie in das angeschlossene Energienetz kann bestenfalls vollständig entfallen. Durch das vorherige Entladen der Energiespeichereinheit kann außerdem das Entladen des Energiespeichers vollständig oder zu einem großen Teil in die Energiespeichereinheit erfolgen. Damit kann das Verfahren besonders kostengünstig durchgeführt werden. Das Entladen der separaten Energiespeichereinheit kann gleichzeitig mit dem Laden des Energiespeichers erfolgen, wenn die Energie aus der Energiespeichereinheit in den Energiespeicher übertragen wird, während dieser vollständig geladen wird.

In vorteilhafter Ausgestaltung der Erfindung umfasst das Laden und/oder das vollständige Entladen des Energiespeichers unter Verwendung einer separaten Energiespeichereinheit zur Aufnahme/Abgabe der Ladung des Energiespeichers ein Laden/Entladen des Energiespeichers nach einem definierten Lade-/Entladeprofil. Dadurch kann sichergestellt werden, dass der Energiespeicher zuverlässig geladen/entladen wird und seine maximale Kapazität korrekt bestimmt werden kann. Beschädigungen des Energiespeichers beim Laden/Entladen können vermieden werden. Gleichzeitig kann das Verfahren effizient durchgeführt werden, da unnötige Zeitverluste durch ein unkontrolliertes Entladen des Energiespeichers verhindert werden.

In vorteilhafter Ausgestaltung der Erfindung erfolgt das Laden und/oder Entladen des Energiespeichers nach einem definierten Lade-/Entladeprofil, beispielsweise das Laden/Entladen mit einer 1/3 C-Rate. Dieses Entlade/Ladeprofil hat sich in der Praxis als solches bereits bewährt. Das Laden/Entladen erfolgt mit einem Drittel der maximalen Kapazität pro Stunde, so dass das vollständige Laden/Entladen des Energiespeichers nach drei Stunden abgeschlossen sein kann. Selbstverständlich können auch andere Lade-/Entladeprofile verwendet werden.

In vorteilhafter Ausgestaltung der Erfindung umfasst das vollständige Entladen/Laden des Energiespeichers unter Verwendung einer separaten Energiespeichereinheit zur Aufnahme/Abgabe der Ladung des Energiespeichers ein Entladen/Laden des Energiespeichers unter Berücksichtigung der Temperatur. Dazu kann beispielsweise das Fahrzeug bzw. nur der Energiespeicher auf eine geeignete Temperatur gebracht werden, um die maximale Kapazität zuverlässig bestimmen zu können. Entsprechend kann eine Vorkonditionierung der Temperatur des Fahrzeugs bzw. des Energiespeichers durchgeführt werden. Die Vorkonditionierung des Energiespeichers kann beispielsweise über eine Batteriemanagementeinheit (BMU) des Fahrzeugs erfolgen, indem die Ladeeinrichtung mit dieser entsprechend kommuniziert.

In vorteilhafter Ausgestaltung der Erfindung umfasst das vollständige Entladen des Energiespeichers unter Verwendung einer separaten Energiespeichereinheit zur Aufnahme der Ladung des Energiespeichers ein Übertragen von Ladung aus der Energiespeichereinheit in ein Energienetz, insbesondere in ein lokales Hausenergienetz und/oder ein direktes Übertragen von Ladung des Energiespeichers in ein Energienetz . Somit kann das Verfahren auch durchgeführt werden, wenn die Energiespeichereinheit eine geringere Kapazität aufweist als der Energiespeicher. Auch kann ohne vorheriges Entladen der Energiespeichereinheit bereits das Verfahren zur Bestimmung der maximalen Kapazität des Energiespeichers durchgeführt werden. Dabei ist die Verwendung der elektrischen Energie in dem lokalen Hausnetz bevorzugt, um ein Zurückspeisen von elektrischer Energie in das Energienetz zu vermeiden.

In vorteilhafter Ausgestaltung der Erfindung umfasst das vollständige Entladen des Energiespeichers unter Verwendung einer separaten Energiespeichereinheit zur Aufnahme der Ladung des Energiespeichers ein Umwandeln von Energie aus der Energiespeichereinheit über einen Verbraucher und/oder ein direktes Umwandeln von Energie des Energiespeichers über einen Verbraucher. Der Verbraucher kann ein Nebenverbraucher der Ladeeinrichtung sein, der üblicherweise über das Energienetz versorgt wird. Auch kann der Verbraucher ein interner Verbraucher sein, wie z.B. eine Kühleinheit der Ladeeinrichtung. Auch ein Verbraucher in einem Hausnetz kann mit der Energie aus der Energiespeichereinheit versorgt werden. Somit kann das Verfahren auch durchgeführt werden, wenn die Energiespeichereinheit eine geringere Kapazität aufweist als der Energiespeicher. Auch kann ohne vorheriges Entladen der Energiespeichereinheit bereits das Verfahren zur Bestimmung der maximalen Kapazität des Energiespeichers durchgeführt werden.

In vorteilhafter Ausgestaltung der Erfindung umfasst das Ermitteln eines Ladezustands des Energiespeichers des Fahrzeugs eine Messung des Ladezustands des Energiespeichers oder eine Abfrage des Ladezustands des Energiespeichers bei einer Managementeinheit des Energiespeichers. Die Messung des Ladezustands kann beispielsweise über die Ladesäule durchgeführt werden. Die Abfrage des Ladezustands wird mittels einer Kommunikation mit der Managementeinheit durchgeführt. Die Managementeinheit wird typischerweise auch als BMU bezeichnet.

In einer weiteren Ausgestaltung der Erfindung kann der Energiespeicher direkt in das Energienetz entladen und/oder direkt aus dem Energienetz geladen werden. Das kann beispielsweise dann erfolgen, wenn die Energiespeichereinheit voll, leer oder defekt ist.

In einer weiteren Ausgestaltung der Erfindung kann das Entladen und/oder das Laden des Energiespeichers parallel in das Energienetz und die Energiespeichereinheit bzw. parallel aus dem Energienetz und der Energiespeichereinheit erfolgen.

In einer weiteren Ausgestaltung der Erfindung kann das erneute Laden des Energiespeichers aus der Energiespeichereinheit bis zum Erreichen seiner maximalen Ladungsmenge erfolgen.

In einer weiteren Ausgestaltung der Erfindung kann das Verfahren ferner Bestimmen der beim erneuten Laden übertragenen Ladungsmenge als maximale Ladekapazität und Ausgeben einer maximalen Kapazität des Energiespeichers auf Basis der maximalen Ladekapazität und der beim vollständigen Entladen des Energiespeichers übertragenen Ladungsmenge (Entladekapazität) aufweisen. Beispielsweise können die maximale Ladekapazität und die Entladekapazität als Einzelwerte, deren Mittelwert sowie deren Differenzen ausgegeben werden.

Nachfolgend wird die Erfindung unter Bezugnahme auf die anliegenden Zeichnungen anhand bevorzugter Ausführungsbeispiele exemplarisch erläutert, wobei die nachfolgend dargestellten Merkmale sowohl jeweils einzeln als auch in Kombination einen Aspekt der Erfindung darstellen können.

Es zeigen:
- Fig. 1: eine schematische Darstellung einer Ladeeinrichtung gemäß einer ersten, bevorzugten Ausführungsform mit einer Chargebox und zwei Ladesäulen, wobei ein Fahrzeug mit einem elektrischen Antrieb an eine der Ladesäulen angeschlossen ist, und
- Fig. 2: ein Ablaufdiagramm eines Verfahrens zur Bestimmung einer maximalen Speicherkapazität eines Energiespeichers des Fahrzeugs aus Fig. 1 zur Durchführung mit der Ladeeinrichtung aus Fig. 1.

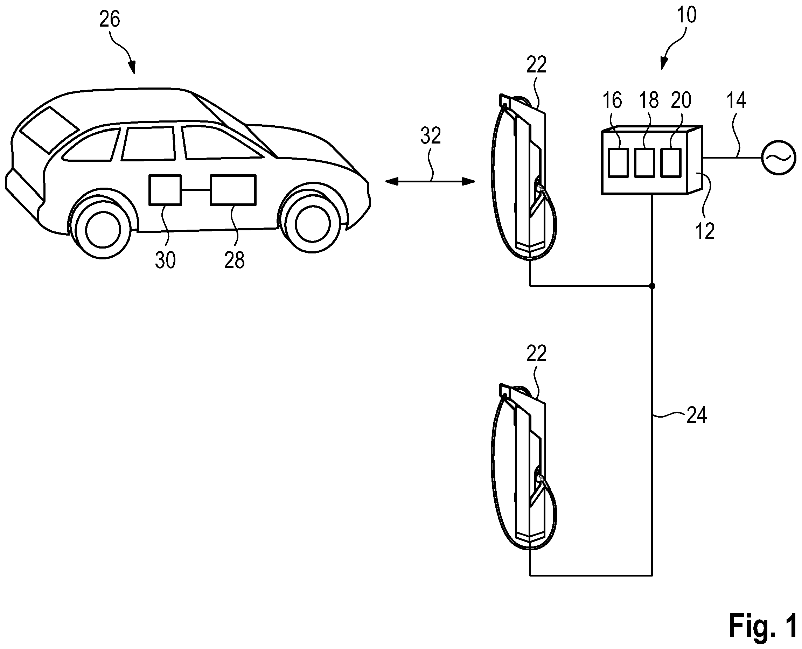

Die Figur 1 zeigt eine erfindungsgemäße Ladeeinrichtung 10 gemäß einer ersten, bevorzugten Ausführungsform. Die Ladeeinrichtung 10 ist zum Schnellladen mit Gleichspannung und Gleichstrom ausgeführt.

Die Ladeeinrichtung 10 umfasst in diesem Ausführungsbeispiel eine Chargebox 12, die an ein Energienetz 14 angeschlossen ist. Die Chargebox 12 ist ausgeführt, elektrische Energie aus dem Energienetz 14 zu entnehmen bzw. elektrische Energie an das Energienetz 14 abzugeben. Das Energienetz 14 ist typischerweise mit Wechselspannung und Wechselstrom ausgeführt.

Die Chargebox 12 umfasst in diesem Ausführungsbeispiel eine Kühleinheit 16, eine Leistungselektronik 18 und eine Energiespeichereinheit 20. Die Kühleinheit 16 dient zur Temperierung der Leistungselektronik 18 und/oder der Energiespeichereinheit 20. Die Leistungselektronik 18 wandelt elektrische Energie aus dem Energienetz 14 in eine Gleichspannung/Gleichstrom um. Auch kann die Leistungselektronik 18 eine Wandlung in umgekehrter Richtung durchführen. Zusätzlich kann die Leistungselektronik 18 eine Wandlung von Gleichspannung/Gleichstrom der Energiespeichereinheit 20 zum Schnellladen mit Gleichspannung und Gleichstrom durchführen, d.h. eine Wandlung der Höhe der Gleichspannung und des Gleichstroms durchführen.

Die Ladeeinrichtung 10 umfasst in diesem Ausführungsbeispiel zwei Ladesäulen 22, die über eine Verbindungsleitung 24 jeweils mit der Chargebox 12 verbunden sind. Entsprechend ist die Chargebox 12 zwischen dem Energienetz 14 und den beiden Ladesäulen 22 angeordnet. Die Ladesäulen 22 werden von der Chargebox 12 mit elektrischer Energie zum Schnellladen mit hohen Gleichspannungen und Gleichströmen versorgt. Auch die Ladesäulen 22 können durch die Kühleinheit 16 gekühlt werden, inklusive Ladekabel der Ladesäulen 22 zum Verbinden mit einem zu ladenden Fahrzeug 26, das ebenfalls in Figur 1 dargestellt ist. In einer besonders bevorzugten Ausführungsform umfasst die Chargebox 12 eine Leistungselektronik 18 für jede der zwei Ladesäulen 22.

Das Fahrzeug 26 umfasst einen Energiespeicher 28 und eine Managementeinheit 30. Das Fahrzeug 26 ist über eine Verbindung 32, die in Figur 1 durch einen Pfeil angedeutet ist, mit einer der Ladesäulen 22 verbunden. Dadurch wird eine Übertragung von elektrischer Energie zwischen dem Energiespeicher 28 und der Chargebox 12 in beiden Richtungen ermöglicht. Die Managementeinheit 30 überwacht den Energiespeicher 28 und ist über die Verbindung 32 neben der Energieübertragung in Kommunikationsverbindung mit der Chargebox 12.

Der Energiespeicher 28 wie auch die Energiespeichereinheit 20 umfassen in diesem Ausführungsbeispiel eine unterschiedliche Anzahl Batteriezellen. Entsprechend haben die Energiespeichereinheit 20 und der Energiespeicher 28 nicht die gleiche maximale Kapazität. Bevorzugt ist die Kapazität der Energiespeichereinheit 20 größer als die Kapazität des Energiespeichers 28. Zusätzlich können sich Abweichungen durch Bauteilschwankungen der Batteriezellen und/oder durch Alterungsprozesse der Batteriezellen ergeben. Die Batteriezellen können dabei prinzipiell in unterschiedlicher Weise parallel und/oder in Reihe geschaltet sein, um jeweils eine gewünschte Kombination aus maximaler Spannung und maximalem Strom zu erreichen.

Entsprechend kann die Ladeeinrichtung 10 zum Schnellladen des Energiespeichers 28, der hier eine Antriebsbatterie des Fahrzeugs 26 mit einem elektrischen Antrieb ist, verwendet werden.

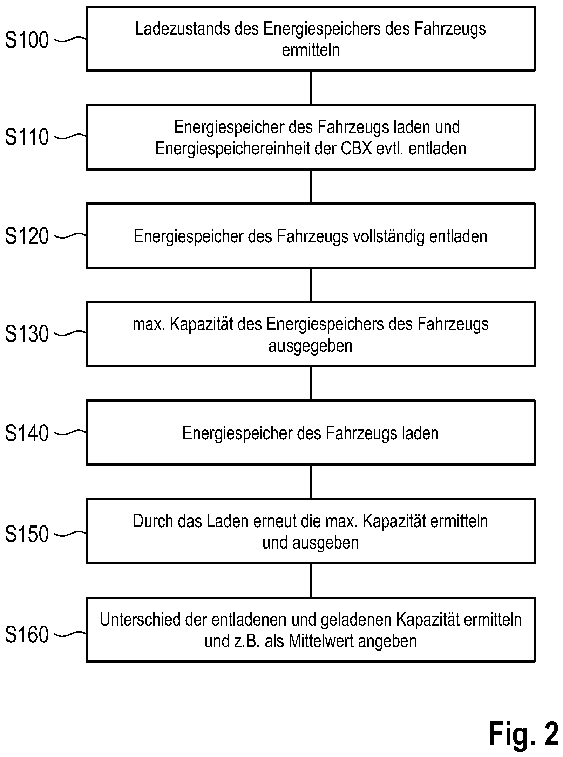

Erfindungsgemäß ist ein Verfahren zur Bestimmung einer maximalen Speicherkapazität des Energiespeichers 28 des Fahrzeugs 26 angegeben, das unter Bezug auf Figur 2 nachstehend beschrieben wird. Das Verfahren wird mit der obigen Ladeeinrichtung 10 durchgeführt.

Das Verfahren beginnt mit Schritt S100, der ein Ermitteln eines Ladezustands des Energiespeichers 28 des Fahrzeugs 26 betrifft. Der Ladezustand des Energiespeichers 28 des Fahrzeugs 26 kann beispielsweise über die Ladesäule 22 gemessen werden. Die Abfrage des Ladezustands wird mittels einer Kommunikation mit der Managementeinheit 30 über die Verbindung 32 durchgeführt.

Schritt S110 betrifft ein Laden des Energiespeichers 28 bis zum Erreichen seiner maximalen Ladungsmenge. Dabei wird gleichzeitig die separate Energiespeichereinheit 20 entladen, und dabei abgegebene elektrische Energie wird zum Laden des Energiespeichers 28 verwendet. Zusätzlich kann der Energiespeicher 28 mit elektrischer Energie aus dem Energienetz 14, z.B. über die Chargebox 12, geladen werden.

In Schritt S120 erfolgt ein vollständiges Entladen des Energiespeichers 28 bevorzugt unter Verwendung der separaten Energiespeichereinheit 20 zur Aufnahme der Ladung des Energiespeichers 28. Dabei wird eine von dem Energiespeicher 28 in die Energiespeichereinheit 20 und/oder in das Energienetz 14 übertragene Ladungsmenge erfasst.

Das Entladen des Energiespeichers 28 erfolgt nach einem definierten Entladeprofil mit z.B. einem 1/3 C. Das Entladen erfolgt so mit einem Drittel der maximalen Kapazität des Energiespeichers 28 pro Stunde, so dass das vollständige Entladen des Energiespeichers 28 nach etwa drei Stunden abgeschlossen ist. Das Entladen des Energiespeichers 28 erfolgt unter Berücksichtigung der Temperatur. Dazu kann das Fahrzeug 26 bzw. nur der Energiespeicher 28 auf eine geeignete Temperatur gebracht werden, um die maximale Kapazität des Energiespeichers 28 zuverlässig bestimmen zu können.

Beim vollständigen Entladen des Energiespeichers 28 wird zunächst Ladung aus dem Energiespeicher 28 in die separate Energiespeichereinheit 20 übertragen und dort aufgenommen. Davon ausgehend kann die elektrische Energie aus der Energiespeichereinheit 20 oder an dieser vorbei weiter in das Energienetz 14 übertragen werden. Zusätzlich kann die in der separaten Energiespeichereinheit 20 aufgenommene Ladung des Energiespeichers 28 über einen Verbraucher umgewandelt werden. Der Verbraucher kann ein Nebenverbraucher der Ladeeinrichtung 10 sein, oder ein interner Verbraucher davon, wie z.B. die Kühleinheit 16.

In Schritt S130 wird aus der übertragenen Ladungsmenge beim vollständigen Entladen des Energiespeichers 28 die maximale Kapazität des Energiespeichers 28 bestimmt und ausgegeben. Die maximale Kapazität des Energiespeichers 28 wird durch einen Energiefluss bei der Entladung des Energiespeichers 28 bestimmt. Dazu werden ein Entladestrom und eine Entladespannung gemessen, wodurch die entladene Energiemenge bestimmt und so auf die maximale Kapazität des Energiespeichers 28 geschlossen werden kann. Die Messung kann in der Chargebox 12 erfolgen. Alternativ oder zusätzlich kann beispielsweise ein in der Ladesäule 22 installiertes DC-Meter verwendet werden, um den Entladestrom und die Entladespannung möglichst unmittelbar zu messen.

In Schritt S140 wird der Energiespeichers 28 nach Möglichkeit/bevorzugt unter Verwendung der separaten Energiespeichereinheit 20 geladen. Sollte die separate Energiespeichereinheit 20 keine Energie aufweisen oder defekt sein, so kann der Ladevorgang auch ausschließlich aus dem Energienetz 14 erfolgen. Entsprechend wird elektrische Energie, die in der Energiespeichereinheit 20 gespeichert ist, an den Energiespeicher 28 übertragen. Soweit erforderlich kann der Energiespeicher 28 zusätzlich mit elektrischer Energie aus dem Energienetz 14 geladen werden.

In einem weiteren optionalen Schritt S150 wird aus der übertragenen Ladungsmenge beim vollständigen Laden des Energiespeichers 28 erneut die maximale Kapazität des Energiespeichers 28 bestimmt und ausgegeben. Die maximale Kapazität des Energiespeichers 28 wird durch einen Energiefluss beim Laden des Energiespeichers 28 bestimmt. Dazu können Ladestrom und Ladespannung gemessen werden, wodurch die geladene Energiemenge unter Berücksichtigung der Ladezeit bestimmt und so auf die maximale Kapazität des Energiespeichers 28 geschlossen werden kann. Die Messung kann in der Chargebox 12 erfolgen. Alternativ oder zusätzlich kann beispielsweise ein in der Ladesäule 22 installiertes Strom- und/oder Spannungsmessgerät verwendet werden, um den Ladestrom und die Ladespannung möglichst unmittelbar zu messen.

In einem weiteren optionalen Schritt S160 werden die geladene und die entladene Kapazität verglichen und beispielsweise als Einzelwerte, Mittelwert und Differenzen ausgegeben.

## Patentansprüche

1. Verfahren zur Bestimmung einer maximalen Speicherkapazität eines Energiespeichers (28), insbesondere als Antriebsbatterie eines Fahrzeugs (26) mit einem elektrischen Antrieb, umfassend die Schritte
Ermitteln eines Ladezustands des Energiespeichers (28) des Fahrzeugs (26), Laden des Energiespeichers (28) bis zum Erreichen seiner maximalen Ladungsmenge,
vollständiges Entladen des Energiespeichers (28) unter Verwendung einer separaten Energiespeichereinheit (20) zur Aufnahme der Ladung des Energiespeichers (28), wobei eine von dem Energiespeicher (28) in die Energiespeichereinheit (20) übertragene Ladungsmenge erfasst wird, und
Ausgeben der übertragenen Ladungsmenge beim vollständigen Entladen des Energiespeichers (28) als maximale Kapazität des Energiespeichers (28).

2. Verfahren nach Anspruch 1, **dadurch gekennzeichnet, dass**
das Verfahren einen zusätzlichen Schritt zum Laden des Energiespeichers (28) unter Verwendung der separaten Energiespeichereinheit (20) zur Abgabe von Ladung an den Energiespeicher (28) aufweist.

3. Verfahren nach einem der Ansprüche 1 oder 2, **dadurch gekennzeichnet, dass**
das Verfahren einen zusätzlichen Schritt zum Entladen der separaten Energiespeichereinheit (20) aufweist, insbesondere zum Laden des Energiespeichers (28).

4. Verfahren nach einem der vorhergehenden Ansprüche, **dadurch gekennzeichnet, dass**
das vollständige Entladen und/oder das Laden des Energiespeichers (28) unter Verwendung einer separaten Energiespeichereinheit (20) zur Aufnahme/Abgabe der Ladung des Energiespeichers (28) ein Laden/Entladen des Energiespeichers (28) nach einem definierten Lade-/Entladeprofil umfasst.

5. Verfahren nach dem vorhergehenden Anspruch 4, **dadurch gekennzeichnet, dass**
das Entladen und/oder das Laden des Energiespeichers (28) nach einem definierten Lade-/Entladeprofil das Laden/Entladen mit 1/3 C umfasst.

6. Verfahren nach einem der vorhergehenden Ansprüche, **dadurch gekennzeichnet, dass**
das vollständige Entladen des Energiespeichers (28) unter Verwendung einer separaten Energiespeichereinheit (20) zur Aufnahme der Ladung des Energiespeichers (28) ein Entladen des Energiespeichers (28) unter Berücksichtigung der Temperatur umfasst.

7. Verfahren nach einem der vorhergehenden Ansprüche, **dadurch gekennzeichnet, dass**
das vollständige Entladen des Energiespeichers (28) unter Verwendung einer separaten Energiespeichereinheit (20) zur Aufnahme der Ladung des Energiespeichers (28) ein Übertragen von Ladung aus der Energiespeichereinheit (20) in ein Energienetz (14), insbesondere in ein lokales Hausenergienetz, und/oder ein direktes Übertragen von Ladung des Energiespeichers (28) in ein Energienetz (14) umfasst.

8. Verfahren nach einem der vorhergehenden Ansprüche, **dadurch gekennzeichnet, dass**
das vollständige Entladen des Energiespeichers (28) unter Verwendung einer separaten Energiespeichereinheit (20) zur Aufnahme der Ladung des Energiespeichers (28) ein Umwandeln von Energie aus der Energiespeichereinheit (20) über einen Verbraucher und/oder ein direktes Umwandeln von Energie des Energiespeichers (28) über einen Verbraucher umfasst.

9. Verfahren nach einem der vorhergehenden Ansprüche, **dadurch gekennzeichnet, dass**
das Ermitteln eines Ladezustands des Energiespeichers (28) des Fahrzeugs (26) eine Messung des Ladezustands des Energiespeichers (28) oder eine Abfrage des Ladezustands des Energiespeichers (28) bei einer Managementeinheit (30) des Energiespeichers (28) umfasst.

10. Verfahren nach einem der vorangehenden Ansprüche, **dadurch gekennzeichnet, dass**
das Entladen und/oder das Laden des Energiespeichers (28) direkt in das Energienetz (14) bzw. direkt aus dem Energienetz (14) erfolgt/erfolgen.

11. Verfahren nach einem der vorangehenden Ansprüche, **dadurch gekennzeichnet, dass**
das Entladen und/oder das Laden des Energiespeichers (28) parallel in das Energienetz (14) und die Energiespeichereinheit (20) bzw. parallel aus dem Energienetz (14) und der Energiespeichereinheit (20) erfolgt/erfolgen.

12. Verfahren gemäß einem der vorangehenden Ansprüche, ferner aufweisend:
erneutes Laden des Energiespeichers (28) aus der Energiespeichereinheit (20) bis zum Erreichen seiner maximalen Ladungsmenge.

13. Verfahren gemäß Anspruch 12, ferner aufweisend:
Bestimmen der beim erneuten Laden übertragenen Ladungsmenge als maximale Ladekapazität und Ausgeben einer maximalen Kapazität des Energiespeichers (28) auf Basis der maximalen Ladekapazität und der beim vollständigen Entladen des Energiespeichers (28) übertragenen Ladungsmenge.

14. Ladeeinrichtung (10) zum Schnellladen eines Energiespeichers (28), insbesondere als Antriebsbatterie eines Fahrzeugs (26) mit einem elektrischen Antrieb, umfassend
eine Ladesäule (22), und
eine Chargebox (12), die zwischen einem Energienetz (14) und der Ladesäule (22) verbunden ist, und der Ladesäule (22) elektrische Energie zum Schnellladen mit hohen Gleichspannungen und Gleichströmen bereitstellt, wobei
die Chargebox (12) eine Energiespeichereinheit (20) aufweist, und
die Ladeeinrichtung (10) ausgeführt ist, das Verfahren nach einem der vorhergehenden Ansprüche durchzuführen.
